Europäisches Patentamt

European Patent Office

Office européen des brevets

(19)

(11) Numéro de publication : **0 006 482**

**B1**

# FASCICULE DE BREVET EUROPÉEN

(12)

(45) Date de publication du fascicule du brevet :
**11.05.83**

(21) Numéro de dépôt : **79101719.7**

(22) Date de dépôt : **01.06.79**

(51) Int. Cl.³ : **H 03 K   5/26, H 03 K   5/08,
H 03 K   5/01, G 01 D   5/38**

(54) Circuit de détection des minima et maxima d'un signal électrique d'amplitude variable et de basse fréquence et application de ce circuit à un appareil permettant de détecter la position et le sens du déplacement de deux pièces l'une par rapport à l'autre.

(30) Priorité : **28.06.78 US 920306**

(43) Date de publication de la demande :
**09.01.80 Bulletin 80/01**

(45) Mention de la délivrance du brevet :
**11.05.83 Bulletin 83/19**

(84) Etats contractants désignés :
**DE FR GB**

(56) Documents cités :
**GB A 1 119 017
US A 2 989 741
US A 3 159 815
US A 3 482 107
US A 3 723 748
IBM   TECHNICAL   DISCLOSURE   BULLETIN
Vol. 20,   no. 8,   Jan.   1978,   New   York   (US)
W. R. YOUNT : « Thresholding   Circuit »   pages
3199-3200**

(73) Titulaire : **International Business Machines Corporation**

**Armonk, N.Y. 10504 (US)**

(72) Inventeur : **Pettit, John Wayne
1732 Tarleton Court
Lexington Kentucky 40504 (US)**

(74) Mandataire : **Buff, Henri C.
COMPAGNIE IBM FRANCE Département de Propriété
Industrielle
F-06610 La Gaude (FR)**

# Circuit de détection des minima et maxima d'un signal électrique d'amplitude variable et de basse fréquence et application de ce circuit à un appareil permettant de détecter la position et le sens du déplacement de deux pièces l'une par rapport à l'autre

## Description

### Domaine Technique

La présente invention concerne un circuit de détection des maxima et minima d'un signal électrique d'amplitude variable et de basse fréquence. Plus particulièrement, elle concerne un circuit qui permet une détection certaine d'un signal qui varie dans le temps en fréquence et en amplitude et présente un courant continu de fuite.

Un autre aspect de l'invention concerne un circuit de détermination de la phase relative de deux signaux électriques de même fréquence instantanée faisant application du circuit de détection défini comme ci-dessus.

Enfin, l'invention concerne un appareil de détection de position et du sens du déplacement relatif de deux pièces l'une par rapport à l'autre faisant application du circuit de détermination de la phase défini comme ci-dessus.

### Etat de la Technique

Dans les machines qui fonctionnent automatiquement, telles que par exemple, les machines outil, les imprimantes, etc., il est bien connu d'utiliser des paires de grilles, ou réseaux, formés par des lignes parallèles comme dispositifs indicateurs de position. Habituellement, une lumière est projetée à travers les grilles ce qui crée une configuration de barres claires/sombres alternées. La configuration de barres est détectée par un détecteur, tel qu'une cellule photoélectrique, disposé de l'autre côté des grilles. Les signaux engendrés par la cellule photoélectrique constituent alors une mesure de la distance parcourue par l'une des grilles par rapport à l'autre et, si ces signaux sont dérivés par rapport au temps, ils donnent également une mesure de la vitesse du déplacement relatif entre les deux grilles.

Un tel système classique présente certains inconvénients. Par exemple, il est difficile de positionner les grilles de telle sorte que les lignes de chaque grille soient maintenues parallèles entre elles ; les surfaces des grilles elles-mêmes doivent être disposées suffisamment proches l'une de l'autre pour produire une image nette. S'il existe un quelconque défaut d'alignement entre les deux grilles, le rapport clair/sombre peut avoir une valeur inférieure au signal de sortie optimal que peut engendrer le détecteur. Un tel défaut d'alignement a pour résultat la perte de signaux, ce qui crée des problèmes en ce qui concerne la machine commandée par le signal de sortie du détecteur. Les tolérances entre deux grilles mobiles doivent être conservées malgré les changements des conditions atmosphériques, l'usure normale des pièces mobiles et le risque, qui n'est que trop réel, que les grilles se rapprochent l'une de l'autre et se touchent, ce qui produit des éraflures, voire l'effacement, d'une ou de plusieurs lignes d'une grille. En outre, si les grilles touchent les éléments optiques et endommagent, par exemple, le détecteur ou la lentille, il y a risque d'une génération incorrecte d'images de barres claires et sombres provoquant de ce fait un fonctionnement défectueux rendant nécessaire le remplacement des grilles relativement onéreuses.

Le brevet des E.U.A. N° 3 524 067, décrit un dispositif de détection de position à grille comportant une grille de lignes mobile, ainsi qu'une source d'éclairement et un détecteur tous deux montés du même côté de la grille, des moyens étant prévus pour renvoyer et focaliser l'image de la grille sur elle-même en un point situé devant le détecteur. Lorsque la grille est déplacée latéralement par rapport à la source lumineuse et au détecteur dans une direction perpendiculaire aux lignes de la grille, les franges d'interférence entre la grille et les lignes de l'image produisent un éclairement et non éclairement alternés du détecteur.

D'une manière similaire, la demande de brevet japonais publiée N° 11793/61 représente, notamment sur sa figure 3, un dispositif de détection optique de position qui comporte une grille, une source lumineuse et un détecteur disposés tous deux du même côté de la grille. Un système optique, qui comporte une lentille et un prisme, réfléchit et focalise l'image des lignes de la grille produite par la source sur la grille à un emplacement situé devant le détecteur. Lorsque la grille se déplace par rapport à la source, au système optique et au détecteur, l'image des lignes de la grille produite par la source est superposée à la grille à un emplacement situé devant le détecteur. Par conséquent, les franges d'interférence entre les lignes de la grille et les lignes de l'image produisent des images claires et sombres alternées sur le détecteur. Dans ce dispositif, la lentille est disposée à une distance égale au double de la distance focale étant donné qu'elle est destinée à focaliser l'image des lignes de la grille sur la grille, tandis que le prisme est placé derrière les lentilles à une distance égale à la distance focale.

Les appareils décrits dans le brevet des E.U.A. N° 3 524 067 et dans la demande de brevet japonais 11793/61 ne paraissent capables que d'effectuer une détection de position.

Le brevet des E.U.A. N° 3 496 364 décrit un codeur linéaire dans lequel une configuration de franges est produite par formation d'une image optique. Le dispositif décrit dans ce brevet comprend une règle graduée et un système optique qui superpose l'image d'une première partie de la règle sur une seconde partie de la règle, cette image étant tournée de 180° dans le plan de la règle. Le déplacement de la règle dans un sens provoque le déplacement de l'image de la règle dans le sens opposé. Il en résulte que la lumière qui traverse la seconde partie de la règle est modulée par le déplacement relatif entre les graduations de la règle et l'image des graduations. En plaçant au moins deux détecteurs photosensibles au niveau de la seconde partie de la règle, ces détecteurs étant séparés dans le sens de la longueur de la règle d'une distance appropriée pour produire des signaux électriques déphasés en réponse à la lumière qui traverse la seconde partie de la règle, le sens de variation de la phase de ces signaux est une représentation du sens de déplacement de la règle tandis que le nombre de cycles des signaux de sortie est une représentation de la distance dont la règle s'est déplacée. Dans ce dernier dispositif, l'information de phase est obtenue en engendrant une configuration de franges d'interférence, de telle sorte que la configuration de franges se déplace à une vitesse ou dans une direction, ou à une vitesse et dans une direction, différentes de celles du déplacement de la règle du codeur. Ceci signifie cependant, qu'un certain grossissement de l'image est nécessaire.

Un article publié dans la revue IBM Technical Disclosure Bulletin, Vol. 20, N° 8, janvier 1978, pages 3199 et 3200 décrit un dispositif à seuil dynamique qui comporte des circuits suiveurs de crêtes positives et négatives, maxima et minima. Le circuit suiveur de crêtes, positives par exemple, suit le niveau de fond d'un signal vidéo d'entrée tandis que le circuit suiveur de crêtes, négatives par exemple, suit les crêtes maximales de l'information vidéo qui correspondent au niveau d'information du noir. Un circuit diviseur, permettant d'établir un rapport entre ces deux niveaux variables, définit le niveau de seuil, dynamique, pour la seconde entrée d'un comparateur qui décide si le signal d'entrée est un signal vidéo ou un signal de fond. De façon à éviter qu'un signal de bruit ne préside à l'élaboration de cette décision, un circuit inhibiteur du signal de fond utilise le signal de sortie, à niveau variable, produit par le circuit suiveur des crêtes positives de façon à appliquer un signal de blocage au circuit diviseur bloquant ainsi les niveaux du signal vidéo à un niveau prédéterminé au-dessous du signal de fond de façon à assurer un rapport minimal pour le comparateur d'entrée. Bien que ce circuit fonctionne de la manière requise pour des signaux de fréquence relativement élevée, il ne fonctionne pas convenablement pour les signaux continus ou pour ceux dont la fréquence est très basse, voire voisine de zéro. En outre, les niveaux de tension de référence, c'est-à-dire les tensions des niveaux de crête, ne s'accroissent pas nécessairement de façon à envelopper toutes les variations du signal au cours d'un cycle complet.

Le document US-A-2 989 741 décrit un circuit produisant un signal présentant la valeur maximum ou minimum d'un signal analogique d'entrée. Selon ce circuit, afin de déterminer la valeur maximum atteinte par le signal d'entrée, un signal de commande est appliqué à une porte commandant le fonctionnement des moyens de détection du maximum tandis qu'est bloqué le fonctionnement des moyens de détection de la valeur minimum dudit signal. Un compteur compte des impulsions ; son contenu, grâce à un convertisseur numérique-analogique, est exprimé sous la forme d'un signal analogique de comparaison, lequel est comparé au signal d'entrée. Le compteur est incrémenté tant que le signal analogique de comparaison a une valeur inférieure à la valeur du signal d'entrée. A l'équilibre, le compteur est arrêté. A la sortie du convertisseur, on recueille alors un signal représentatif du maximum du signal d'entrée. Entre chaque opération de détermination d'une valeur extrême, le compteur doit être remis à zéro. Dans ce circuit, il n'est pas possible d'avoir simultanément la valeur des crêtes maximum et minimum du signal d'entrée puisque le compteur est utilisé à tour de rôle pour l'expression des minimum et maximum du signal d'entrée.

Les problèmes que l'invention se propose de résoudre sont notamment :

— la réalisation d'un circuit de détection qui engendre un signal de sortie, dont la fréquence est fonction de celle du signal d'entrée, mais qui est insensible aux variations maximum d'amplitude du signal d'entrée, lequel varie en fréquence et en amplitude, et en présence d'un courant continu de fuite ;

— la réalisation d'un circuit de détection du signal de sortie d'un dispositif optique de détection de la position d'un élément : une grille, par rapport à un autre : un bloc optique d'illumination de la grille et de détection de la lumière réfléchie, lequel circuit est relativement insensible à la forme du signal d'entrée, de façon à empêcher les erreurs de détection, et qui délivre une tension de référence fonction à la fois de l'amplitude des maxima et de l'amplitude des minima du signal.

### Exposé de l'invention

Selon l'invention, le circuit de détection est destiné à engendrer un signal de sortie à partir d'un signal d'entrée dont la fréquence et l'amplitude varient, en présence d'un courant continu de fuite. Il comporte des premiers moyens pour engendrer une première tension de référence destinés à suivre les maxima d'amplitude du signal d'entrée, et des seconds moyens pour engendrer une seconde tension de référence destinés à suivre les minima d'amplitude du signal d'entrée.

Des moyens déterminent à partir des première et seconde tensions de référence, une tension de seuil de détection qui varie en fonction de ces tensions de référence. Des moyens de comparaison entre la tension de seuil de détection et le signal d'entrée comprennent un circuit comparateur à deux bornes d'entrée dont la première reçoit le signal d'entrée et dont la seconde reçoit la tension de seuil de détection.

Le circuit de détection selon l'invention est caractérisé en ce que les premier et second moyens comprennent des premier et deuxième comparateurs permettant les comparaisons respectives des première et seconde tensions de référence avec le signal d'entrée, et des premier et second compteurs, l'entrée d'incrémentation du premier compteur étant reliée à la sortie du premier comparateur et l'entrée de décrémentation du second compteur étant reliée à la sortie du deuxième comparateur.

Des circuits logiques reliés à la borne de sortie du circuit comparateur sont connectés d'une part à la borne de décrémentation du premier compteur afin de le décrémenter lorsque l'amplitude croissante du signal d'entrée coïncide avec la tension de seuil de détection, le signal de sortie du circuit de détection étant constitué par le signal de décrémentation appliqué à la borne de décrémentation du premier compteur, et d'autre part à la borne d'incrémentation du second compteur afin de l'incrémenter lorsque l'amplitude décroissante du signal d'entrée coïncide avec cette tension de seuil de détection, la sortie du premier et celle du second compteur délivrant respectivement les première et seconde tensions enveloppant l'amplitude crête-à-crête du signal d'entrée au cours d'un cycle complet de celui-ci.

Toujours selon l'invention, il est fait utilisation du circuit de détection ainsi défini pour réaliser un circuit de détermination de la phase relative de deux signaux électriques de même fréquence instantanée. Ce circuit de détermination comprend un premier canal formé par le circuit de détection décrit ci-dessus, un second canal identique au premier canal, le premier et le second canal recevant respectivement le premier et le second signal, et des moyens recevant les signaux de sortie du premier et du second canal, qui indiquent dans leur signal de sortie la relation de phase entre ces signaux de sortie des premier et second canaux.

L'invention se propose encore de réaliser un appareil de détection de position et du sens du déplacement relatif de deux pièces l'une par rapport à l'autre par utilisation du circuit de détermination de la phase défini ci-dessus.

Cet appareil comprend une grille formée d'un premier et d'un second ensemble de lignes opaques et de lignes transparentes à la lumière, inscrites sur du matériau transparent, le premier ensemble étant juxtaposé au second ensemble de telle sorte que le premier ensemble de lignes soit décalé par rapport au second ensemble de lignes selon le sens du déplacement relatif et un ensemble source lumineuse-détecteur de lumière consistant en deux sources lumineuses et deux détecteurs de lumière, chaque source lumineuse étant associée à un seul détecteur de lumière pour former une paire de dispositifs de génération et de détection de lumière, chacune des deux paires étant placée d'un même côté de la grille.

Dans cet appareil, la première paire est placée de telle sorte qu'un des deux dispositifs de la première paire est aligné avec le premier ensemble de lignes tandis que le second dispositif de cette première paire est aligné avec le second ensemble de lignes, et les deux dispositifs de la seconde paire sont alignés avec seulement un des ensembles de lignes de la grille.

De plus, l'axe de révolution d'une surface réfléchissante, placée de l'autre côté de la grille par rapport à l'ensemble source lumineuse-détecteur de lumière, passe par le point milieu de chaque segment déterminé par la source lumineuse et par le détecteur de lumière appartenant à une même paire de dispositifs.

De plus, le déplacement relatif entre la grille et l'ensemble source lumineuse-détecteur de lumière est détecté du fait du déplacement de l'image des lignes opaques et des lignes transparentes de la grille devant les deux détecteurs, qui délivrent chacun un signal de sortie dont la différence de phase relative varie en fonction du mouvement relatif.

Cet appareil comprend encore un circuit de détermination, tel qu'indiqué plus haut, permettant de détecter la phase relative d'un premier signal électrique issu du premier détecteur de lumière et d'un second signal électrique issu du second détecteur de lumière, et de générer un signal de sortie représentatif de ces variations de phase.

Enoncé des Figures

La figure 1 est une vue fragmentaire, en perspective, d'une partie d'une machine, dans le cas représenté : une imprimante à jet d'encre, qui comporte un appareil fonctionnant avec un détecteur des minima et des maxima d'un signal électrique.

La figure 2 est une représentation schématique de la position de certaines parties de l'appareil représenté sur la figure 1.

Les figures 3 et 15 sont des vues fragmentaires, agrandies de deux modes de réalisation d'une bande porte-grille qui peut être utilisée pour générer les signaux à traiter par le détecteur de la présente invention, la figure 3 montrant également la position relative de l'ensemble formé des sources lumineuses et des détecteurs tel qu'ils apparaîtraient si l'on regardait à travers la bande portant la grille.

La figure 4 est une vue schématique, en élévation latérale, de l'appareil représenté sur la figure 2 montrant la réflexion d'un rayon issu d'une source lumineuse et tombant sur un détecteur.

La figure 5 est une vue, à plus grande échelle, représentant un ensemble de sources lumineuses et de détecteurs qui peut être employé.

La figure 6 représente la forme du signal de sortie de l'un des détecteurs de l'ensemble de sources et de détecteurs.

La figure 7 est un schéma-bloc de l'appareil qui, raccordé aux deux détecteurs, produit un signal de sortie indicatif à la fois de la position de l'ensemble mobile de l'appareil représenté sur figure 1, et de son sens de déplacement et qui incorpore le circuit détecteur de la présente invention.

La figure 8 est un schéma-bloc du circuit formant l'un des canaux représentés sur la figure 7.

La figure 9 est un graphique sur lequel a été tracé une forme d'onde similaire à celle de la figure 6, mais qui montre comment le niveau de seuil est obtenu pour assurer un fonctionnement correct des circuits représentés sur les figures 7 et 8.

La figure 10 est un autre schéma qui représente le circuit de l'élément logique POR représenté schématiquement sous la forme d'un cadre sur la figure 8.

La figure 11 est un diagramme des temps représentant les diverses formes d'onde à certains instants d'un cycle, ces formes d'onde correspondant spécifiquement aux circuits des figures 8 et 10.

La figure 12 est un schéma d'un circuit anti-rebondissement inclus dans le schéma de la figure 8.

La figure 13 est un diagramme des temps correspondant au circuit de la figure 12, et

La figure 14 est un diagramme sur lequel ont été tracées les formes des signaux de sortie produits par les circuits représentés aux figures 7, 8, 10 et 12.

La figure 16 est une vue en coupe suivant la ligne 16-16 de la figure 5.

### Description d'un mode de réalisation de l'invention

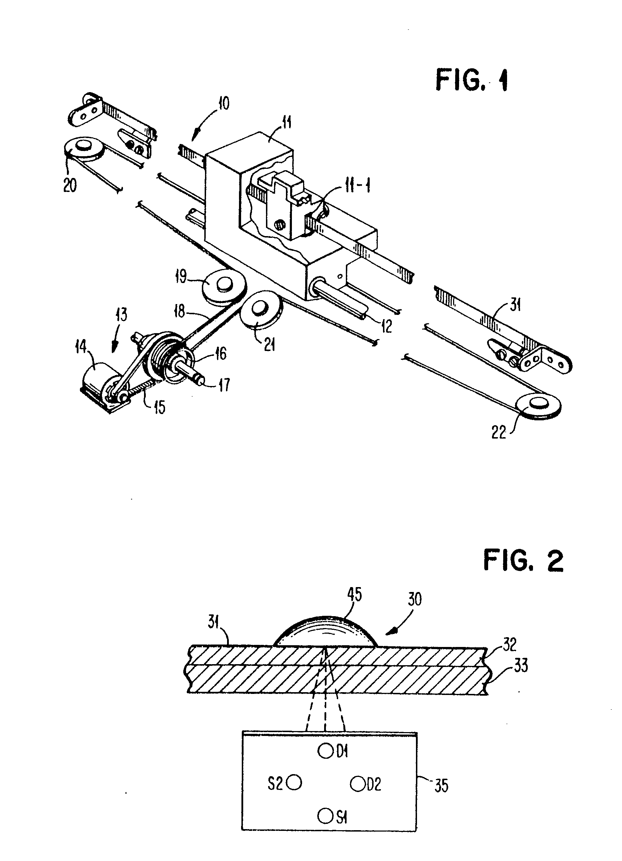

On se référera maintenant aux dessins et, en particulier, à la figure 1 sur laquelle on a représenté une machine, dans le cas choisi, une partie d'une imprimante à jet d'encre, qui peut comporter le circuit détecteur de la présente invention. Mais il est bien évident que toute autre machine, comportant un élément mobile dont il y a lieu de déterminer la position par rapport à un élément de référence, pourrait être décrite ici, sans sortir du cadre de la présente invention.

Ainsi donc, un chariot 11 est monté coulissant sur une tige 12 ; le chariot comporte les organes courants nécessaires pour l'impression par jet d'encre : une buse, une électrode de charge, des plaques de déviation et un collecteur d'encre (pour remettre les gouttelettes non chargées), le tout pour propulser les gouttelettes d'encre vers une platine d'impression (non représentée) afin d'effectuer une impression sur un support récepteur de gouttelettes d'encre porté par la platine. Le chariot 11 se déplace le long de l'arbre 12 grâce aux moyens d'entraînement 13 qui comportent un moteur 14 raccordé par une courroie 15 à un tambour à câble 16 monté à rotation sur un arbre support 17. Un câble 18 est enroulé sur le tambour 16, passe d'un côté autour de poulies 19 et 20 et de l'autre côté autour de poulies 21 et 22 pour aboutir aux côtés opposés du chariot auquel il est raccordé. Par conséquent, lorsque le moteur 14 tourne, le chariot est déplacé dans un sens ou dans l'autre le long de la tige 12.

Il est essentiel pour l'opération d'impression : (1) que la position précise du chariot (et ainsi, celle de la buse qui produit le jet d'encre) soit connue en tout point de la course du chariot ; et (2) que le sens de déplacement du chariot soit connu des circuits électroniques utilisés pour la formation du courant d'encre qui permet l'impression. A cette fin, on utilise un appareil 30 de détection optique de position (figure 2) qui comporte une grille 31 comportant un premier et un second ensembles 32 et 33 de lignes opaques et de lignes transparentes destinées à coopérer avec un ensemble 35 de sources lumineuses et de détecteurs de lumière disposé d'un côté de la grille et un élément 45 réflecteur d'image disposé de l'autre côté de la grille. L'élément 45 réflecteur d'image, l'ensemble 35 de sources et de détecteurs, en combinaison avec la grille 31, constituent le dispositif optique réalisé conformément à la présente invention. La grille 31, qui peut être constituée par une bande souple en « Mylar » sur laquelle des zones sombres (appelées encore lignes opaques) ont été formées par un procédé photographique, est montée de façon à être stationnaire par rapport au chariot mobile 11, (cf. grille 31, figure 1) mais naturellement, le chariot pourrait être stationnaire et des moyens pourraient être prévus pour déplacer la grille. La grille 31 passe dans une fente appropriée 11-1 pratiquée dans le chariot tandis que l'ensemble 35 de sources et de détecteurs et l'élément réflecteur d'image 45 sont montés sur le chariot de part et d'autre de la grille (cf. figure 2, qui montre la position relative de ces éléments).

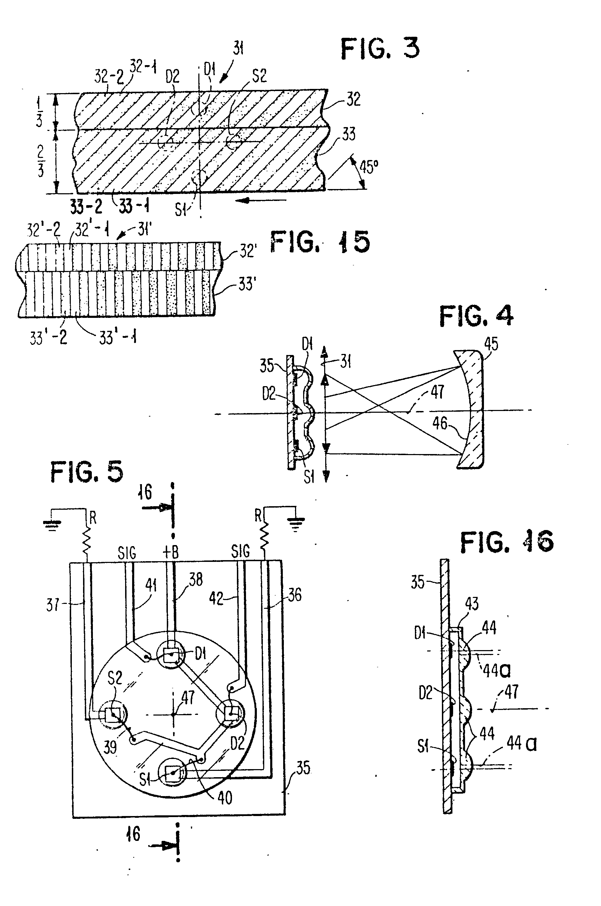

Les grilles types qui peuvent être utilisées dans l'appareil de la présente invention ont été représentées sur les figures 3 et 15, dans lesquelles, de mêmes éléments portent des références identiques au signe prime près. La grille 31, représentée sur la figure 3 est utilisée, pour des raisons qui apparaîtront plus clairement ci-après, dans un appareil de détection optique de position dans lequel la surface réfléchissant l'image a une courte distance focale. L'emploi de la grille 31' (figure 15) est acceptable dans les appareils utilisant une plus grande distance focale. Comme représenté sur la figure 3 (et sur la figure 15), chaque grille 31 (31') comporte deux ensembles 32, 33 (32' et 33') de lignes opaques et transparentes désignées respectivement par les références 32-1, 32-2, 33-1, 33-2 dans le cas de la grille 31 ; 32'-1, 32'-2, 33'-1, 33'-2 dans le cas de la grille 31'. Comme représenté, l'un des ensembles, par exemple l'ensemble 32 (ou 32') est décalé par rapport à l'autre ensemble 33 (ou 33') de lignes opaques et transparentes, cet ensemble étant disposé sur la grille au-dessus de l'autre ensemble. Le décalage est, de préférence, de 90° pour des raisons qui apparaîtront également plus clairement ci-après.

La position relative de l'élément 45 réflecteur d'image et de l'ensemble 35 de sources et de détecteurs par rapport à la grille 31 (ou 31') a été plus particulièrement représentée sur la figure 4.

La surface réfléchissant l'image est, de préférence, une calotte sphérique représentée, ici, par la surface concave 46, la grille 31 (ou 31') étant disposée dans un plan perpendiculaire à l'axe optique 47 du miroir et disposée en coïncidence avec le centre de la calotte sphérique de façon à donner un grossissement de 1. Ainsi, la distance mesurée le long de l'axe 47 optique entre la calotte sphérique 46 et la grille 31 est égale au rayon de courbure de la calotte sphérique.

L'ensemble 35 (figure 4) comportant les sources lumineuses S1 et S2 (dont une seule S1 a été représentée) et les détecteurs D1 et D2 a été plus particulièrement représenté sur les figures 5 et 16. Cet ensemble comporte des paires de dispositifs formés chacun par une source lumineuse et un détecteur de lumière, désignés respectivement par les références S1, D1 et S2, D2. La source S1 doit être située à la même distance de l'axe optique 47 de la surface 46 réfléchissant l'image que le détecteur D1 et dans un même plan passant par cet axe ; autrement dit, le segment déterminé par la source S1 et par le détecteur D1, voit son point milieu coupé par l'axe optique 47. La source S2 doit être située à la même distance de cet axe 47 que le détecteur D2 et dans le même plan. Bien que, pour des fins de commodité, les sources lumineuses S1 et S2 et les détecteurs D1 et D2 représentés sur la figure 5 soient tous quatre situés à la même distance de l'axe optique de la surface 46 réfléchissant l'image, il y a lieu de comprendre que les deux dispositifs de chaque paire doivent être situés à la même distance de cet axe 47 pour que l'appareil fonctionne correctement. De même, on comprendra que si les ensembles S1, D1 et S2, D2 sont dans des plans orthogonaux passant par l'axe optique 47, le fonctionnement de l'invention n'en sera pas moins correct si lesdits plans ne sont pas orthogonaux.

En outre, comme représenté schématiquement sur la figure 3 le dispositif détecteur de lumière D1 doit se trouver en face de l'ensemble 32 de lignes opaques et de lignes transparentes 32-1, 32-2 tandis que l'autre dispositif de la paire, la source S1 dans le présent cas, doit être aligné avec l'autre ensemble 33 de lignes opaques et de lignes transparentes 33-1, 33-2 de la grille 31. L'autre paire de dispositifs formant source lumineuse et détecteur de lumière S2-D2 peut être alignée avec l'un ou l'autre ensemble de lignes opaques et transparentes ; dans le présent cas, la paire de dispositifs S2-D2 est alignée avec l'ensemble 33. De cette manière, l'image de la région de la grille éclairée par la source disposée en face d'elle est renvoyée sur la région de la grille située devant le détecteur correspondant par la surface 46 réfléchissant l'image. Étant donné que les régions éclairées par S1 et S2 présentent une différence de phase constante, les images réfléchies présentent également la même différence de phase : ici, les lignes de la grille situées devant les détecteurs D1 et D2 sont décalées de 90°, comme décrit ci-dessus. Les signaux de sortie des détecteurs présentent donc une différence de phase constante au cours du temps qui permet la détection du sens de déplacement du chariot 11.

Comme plus particulièrement représenté sur les figures 5 et 16, l'ensemble 35 de sources et de détecteurs est, de préférence, monté sur un support du type plaquette de circuit afin de faciliter son raccordement au câblage de chariot (bien que les éléments et les dispositifs ainsi que les connexions puissent être constitués et réalisés par tous moyens appropriés qui permettent de respecter les règles de positionnement par rapport à l'axe optique 47 comme indiqué ci-dessus). Comme plus particulièrement représenté sur la figure 5, la plaquette de circuit porte des lignes conductrices 36 et 37 déposées sur le substrat qui raccordent les sources S1 et S2 à la masse, par exemple avec interposition de résistances chutrices R. L'une des microplaquettes de détecteur (phototransistors) D1 et D2 est connectée par un conducteur 38 à une source de courant + B, cette source positive étant également connectée par des fils soudés 39 et 40 aux sources S1 et S2 qui sont, dans l'exemple représenté, des diodes électroluminescentes. Comme il est habituel, les signaux de sortie (SIG) des détecteurs photosensibles D1 et D2 sont prélevés sur des conducteurs 41 et 42.

De préférence, une lentille 43 (figure 16) est fixée au substrat, cette lentille étant fabriquée par exemple dans une feuille de méthyl-méthacrylate qui sert de couvercle de protection et comporte une partie 44 formant lentille au-dessus de chacun des dispositifs S1 et S2, D1 et D2 de façon à contribuer à focaliser à la fois la lumière émanant des sources S1 et S2 et la lumière reçue de la surface 46 réfléchissant l'image et ayant traversé la grille. Comme plus particulièrement représenté sur la figure 16, l'axe optique 44a de chacune des lentilles 44 est légèrement décalé par rapport à l'axe du dispositif correspondant en direction de l'axe optique 47 de la calotte 46 de façon à assurer l'utilisation maximale de la lumière émise ainsi que de la lumière reçue, sans aberration.

Avec des miroirs concaves ayant une faible distance focale, il est désirable d'utiliser la grille 31 de la figure 3 dans laquelle les lignes opaques et transparentes sont inclinées à 45° pour réduire l'effet des aberrations. Les causes fondamentales de telles aberrations ont été décrites en détail dans un article intitulé « Astigmatism and Spherical Mirror » publié dans le numéro de septembre 1977 de la revue « Electro Optical Systems Design » pages 27 et suivantes. Ainsi, dans le cas où la qualité de l'image est importante et où l'inverse de l'ouverture du miroir (défini par le rapport distance focale/diamètre du miroir) est égal ou inférieur à 2, la grille 31 représentée sur la figure 3 devrait être employée. Ceci permet aux signaux de sortie des détecteurs D1 et D2 de présenter une même valeur crête lorsque D1 et D2 sont placés dans un même plan perpendiculaire à l'axe optique 47. Ce résultat est obtenu initialement par réglage expérimental du miroir et des sources S et des détecteurs D.

Avec des distances focales plus grandes ou dans les situations dans lesquelles les aberrations astigmatiques sont sans importance, la grille 31' de la figure 16 peut être utilisée. A cet égard, étant donné que le grossissement du système est de 1 et que le déplacement relatif entre le chariot et la grille a pour effet d'engendrer des franges d'interférence, il est judicieux d'adopter une largeur des lignes opaques de 60 % et une largeur des lignes transparentes de 40 % de façon à produire un effet meilleur et plus stable, c'est-à-dire une meilleure configuration de franges d'interférence. Cependant, il n'est pas essentiel que les largeurs des lignes soient dans le rapport indiqué, un rapport 50-50 ou même un rapport inférieur convenant pour la plupart des applications. En outre, étant donné qu'il suffit qu'un dispositif d'une des paires de dispositifs soit aligné avec l'un des ensembles de lignes opaques et transparentes, il n'est pas nécessaire que les ensembles aient la même hauteur. Par exemple, l'ensemble 32 (ou 32') peut ne s'étendre que sur un tiers de la largeur de la grille, tandis que l'ensemble 33 (ou 33') s'étend sur les deux autres tiers.

Si les grilles sont des grilles grossières, les signaux de sortie des détecteurs D1 et D2 peuvent être amplifiés, écrêtés puis détectés afin de déterminer à la fois la position relative et le sens de déplacement relatif entre le chariot et la grille. Cependant, dans une machine telle qu'une imprimante à jet d'encre, il est impératif que la grille soit de haute qualité (et comporte, par exemple, 95 lignes au cm) et que la détection soit précise aussi bien en ce qui concerne la détermination de la position que la détermination du sens de déplacement. Cependant, ceci présente une difficulté du fait de l'incapacité d'obtenir une détection précise d'un signal variant en fréquence et en amplitude, en utilisant une tension de seuil de détection pré-réglée. Par conséquent, le dispositif de détection formé par l'ensemble de détecteurs et de sources, la grille et la surface réfléchissant l'image de la présente invention, établit le seuil de détection en fonction des niveaux de crête et de creux, ou maxima et minima, du signal précédent.

Conformément à la présente invention, le circuit établit la tension de seuil de détection du signal issu d'un détecteur, qui varie en fréquence et en amplitude, et en présence d'un courant continu de fuite, compare la tension de seuil de détection au signal du détecteur et engendre un signal de sortie, tel qu'un signal à forme rectangulaire, dont la fréquence est fonction de la fréquence du signal d'entrée.

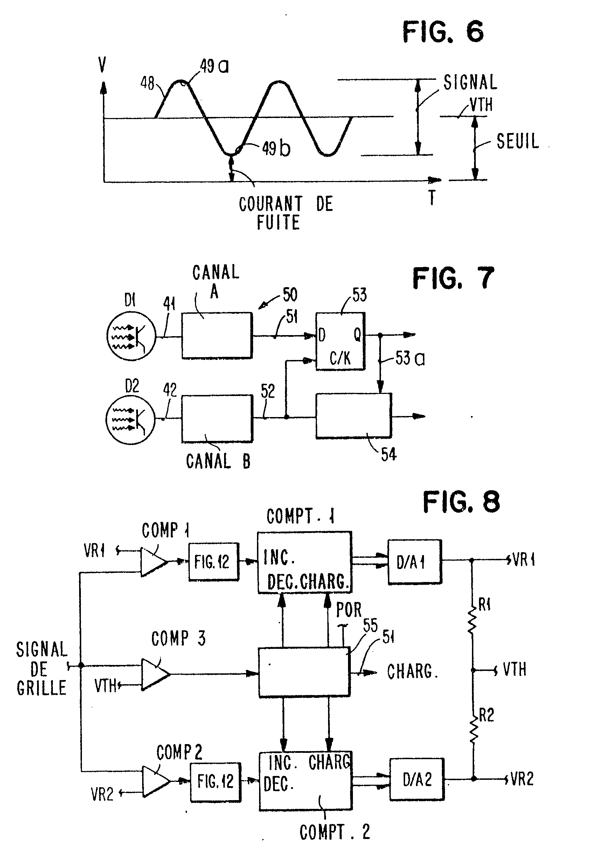

Sur la figure 6, on a représenté un signal de sortie type d'un détecteur. La forme du signal produit par l'un ou l'autre des détecteurs D1 et D2 est essentiellement une forme d'onde triangulaire 48 avec des crêtes arrondies 49a et des creux arrondis 49b. Du fait que l'obturation par la grille de l'image réfléchie sur cette grille est imparfaite, l'amplitude du signal produit varie. De plus les creux de ce signal sont situés au-dessus du niveau OV, à une distance dont la valeur correspond au courant continu de fuite. La tension du niveau de seuil de détection VTH désirée est réglée en fonction du maximum et du minimum du signal, c'est-à-dire à la crête 49a et au creux 49b du signal 48. Du fait du courant continu de fuite, des imperfections de la largeur des lignes opaques ainsi que de la largeur des lignes claires, de la poussière, des éraflures, etc. qui peuvent se trouver sur la bande portant la grille, ou même sur l'ensemble de sources et de détecteurs, le signal de sortie varie en amplitude ; la tension du niveau de seuil de détection varie, ce faisant. Comme on le décrira ci-après, la tension du niveau de seuil de détection VTH suit les variations du signal de sorte que la détection puisse s'effectuer au niveau correct, cette capacité étant importante lors de la détection du signaux de grille en quadrature pour que soit conservée l'information relative aux phases des signaux.

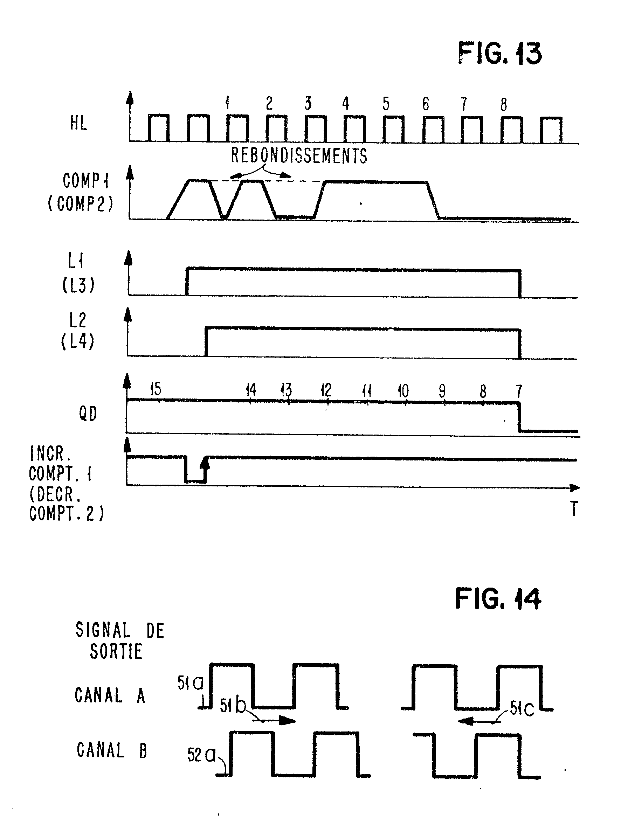

Le circuit électrique 50 a été représenté sur la figure 7. Les signaux de sortie des détecteurs D1 et D2 sont appliqués directement au canal A et au canal B pour produire sur des lignes 51 et 52 des signaux de sortie ayant respectivement les formes d'onde 51a et 52a représentées sur la figure 14. On notera que le signal de sortie, rectangulaire, a une fréquence liée à la fréquence du signal d'entrée ; dans le présent cas, il est à la même fréquence. Une bascule 53 du type à retard ayant une entrée d'horloge (C/K) raccordée à la sortie du canal B a une seconde entrée D raccordée à la sortie du canal A et une sortie Q indiquant si le chariot, dans le présent cas le chariot 11 de l'imprimante à jet d'encre, se déplace de gauche à droite, comme indiqué par la flèche 51b sur la figure 14 ou s'il se déplace de droite à gauche dans le sens de la flèche 51c comme ceci est le cas au cours du cycle de retour du chariot. Par exemple, supposons que le chariot se déplace dans le sens indiqué par la flèche 51b : si le signal rectangulaire 51a est à un haut niveau lors de la réception par la bascule 53 du front avant du signal 52a (du canal B), le signal de la sortie Q de la bascule 53 peut être un 1 numérique. Par contre, si le signal 51a est à un bas niveau lorsque le front avant du signal de sortie 52a est appliqué à la bascule 53, le signal de sortie Q de la bascule 53 est à un niveau logique 0 indiquant que le chariot se déplace dans le sens de la flèche 51c. En outre, le signal de sortie 52a du canal B peut être appliqué à un compteur 54 qui reçoit également le signal de la sortie Q de la bascule 53 qui lui est transmis par la ligne 53a pour indiquer au compteur s'il doit compter dans le sens progressif ou dans le sens régressif. Le signal de sortie du compteur est alors une représentation (numérique) de la position exacte à laquelle se trouve le chariot à un moment donné quelconque au cours de son déplacement de gauche à droite ou de droite à gauche.

Etant donné que le circuit du canal A et celui du canal B sont identiques, on décrira le circuit d'un seul canal, par exemple le canal A, en se référant aux figures 8 à 13. Le nouveau circuit de détection décrit ci-après en se référant aux figures ci-dessus mentionnées, résout les problèmes de détection des signaux de basses fréquences liées aux divers procédés de détection décrits dans la technique antérieure. Le circuit décrit ci-après peut fonctionner en courant continu et aux très basses fréquences rencontrées lors du démarrage du chariot par rapport à la grille.

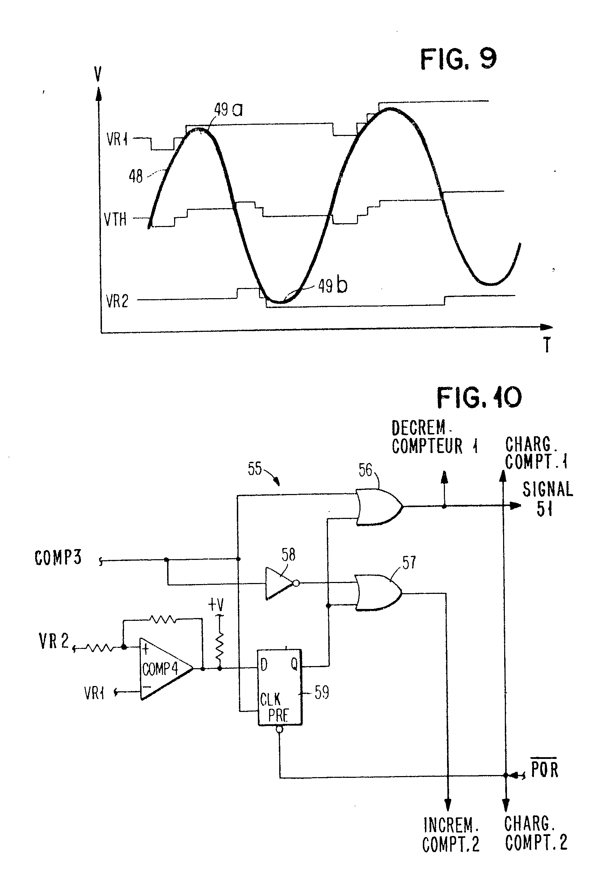

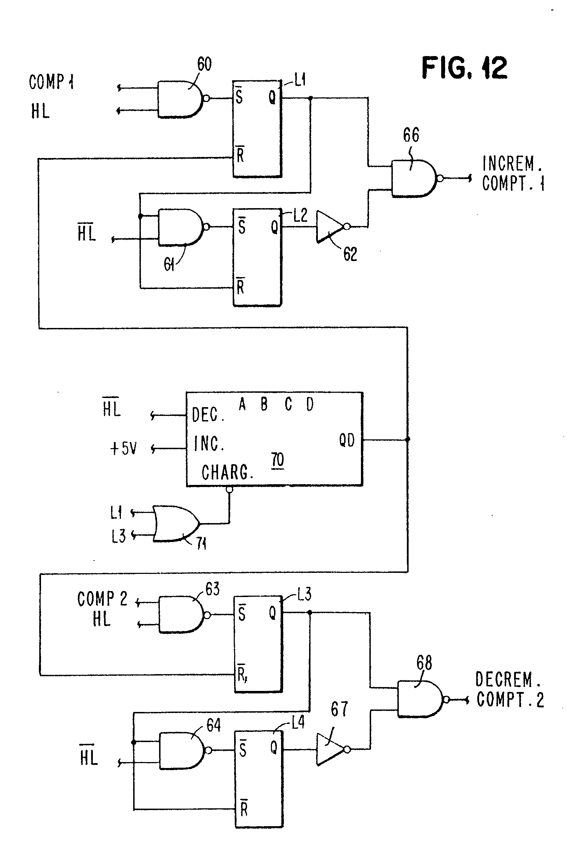

On se référera maintenant aux figures 8 et 9. Le circuit engendre des tensions de référence VR1 et VR2 qui suivent respectivement les crêtes 49a et les creux 49b du signal de grille 48 (figure 6) par échelons quantifiés. Essentiellement, le signal de grille est prélevé sur la ligne conductrice 41 du substrat 35 représenté sur la figure 5, et appliqué à une des entrées de chacun de trois comparateurs COMP1, COMP2 et COMP3. Le signal de chacun des comparateurs COMP1 et COMP2 peut être appliqué à un circuit désensibilisateur représenté sur la figure 12 et qui sera décrit plus en détail ultérieurement. Le signal du comparateur COMP1 est appliqué à un compteur progressif/régressif désigné compteur 1, puis à un convertisseur numérique/analogique D/A1 pour fournir le signal de tension de référence VR1. De même, le signal de sortie du comparateur COMP2 est appliqué à une autre partie du circuit désensibilisateur représenté sur la figure 12 puis à un compteur désigné compteur 2 et ensuite à un convertisseur numérique/analogique D/A2 pour produire le signal de tension de référence VR2. Les comparateurs COMP1 et COMP3 le compteur 1 et le convertisseur D/A1 remplissent une fonction d'échantillonnage et de maintien des crêtes du signal de grille 48 (figure 6), telles que la crête 49a. De même, les comparateurs COMP2 et COMP3, le compteur 2 et le convertisseur D/A2 remplissent une fonction d'échantillonnage et de maintien des creux 49b du signal 48. Les résistances R1 et R2 sont utilisées pour produire la tension du niveau de seuil de détection VTH. Comme il apparaîtra plus clairement ci-après, la tension du niveau de seuil de détection VTH peut être calculée à partir de l'équation : $VTH = VR1 \cdot (R2) + VR2 \cdot (R1)/(R1 + R2)$. Le rapport R1 : R2 peut être choisi selon la forme du signal de grille pour produire le coefficient d'utilisation désiré du signal de sortie. Par exemple, un coefficient d'utilisation de 50 % pour un signal de grille triangulaire nécessiterait que R1 soit égal à R2.

Supposons que le chariot 11 se déplace de gauche à droite par rapport à une grille fixe 31. Le signal de grille 48 (à pente positive) franchit la tension du niveau de seuil de détection VTH qui a été réappliquée au comparateur COMP3 tandis que les tensions VR1 et VR2 ont été respectivement réappliquées au comparateur COMP1 et au comparateur COMP2. Le comparateur COMP3 bascule, ou change d'état, ce qui provoque la décrémentation du compteur 1 d'une unité de sorte que la tension VR1 est réduite à une valeur inférieure à la valeur de la crête qui suit immédiatement, par exemple la crête 49a du signal 48 (cf. figure 9). Le signal de grille s'accroissant, le signal franchit le niveau de tension de référence VR1 maintenant réduit, ce qui provoque le basculement du comparateur COMP1 ce qui incrémente le compteur d'une unité. Ceci provoque un accroissement du niveau de tension de référence VR1. (La vitesse de fonctionnement des circuits logiques doit, naturellement, être supérieure à celle des changements du signal de grille, ce qui constitue une limitation pratique de la fréquence du signal de grille). De cette manière, le signal de grille incrémente, de manière répétée, la tension de référence VR1 jusqu'à ce que cette tension dépasse et enveloppe la nouvelle crête 49a du signal. D'une manière similaire, lorsque le signal de grille franchit la tension du niveau de seuil de détection VTH avec une pente négative, le comparateur COMP3 bascule, provoquant l'incrémentation du compteur 2 d'une unité, de sorte que la tension de référence VR2 est accrue au-dessus du creux suivant 49b du signal (c'est-à-dire qu'elle s'élève et se rapproche de la tension VTH). Le signal de grille continuant de s'abaisser (en devenant plus négatif par rapport à la tension VTH), il franchit la nouvelle tension de référence VR2 ce qui provoque le changement d'état du comparateur COMP2, ce qui provoque la décrémentation du compteur d'une unité. Il en résulte que la tension de référence VR2 diminue d'une quantité prédéterminée, ce qui rend à nouveau la tension de référence VR2 plus petite que le creux du signal. Comme dans le cas de la tension de référence VR1, la tension de référence VR2 est décrémentée de manière répétée jusqu'à ce qu'elle soit réduite au-dessous du nouveau creux 49b du signal 48. De cette manière, la valeur de la tension du niveau de seuil de détection VTH au point de la détection du seuil est ainsi proportionnelle aux valeurs de la crête et du creux précédents du signal 48, étant donné que les niveaux de tension de référence engendrés VR1 et VR2 ont enveloppé l'oscillation maximum du signal au cours d'un cycle complet. A cet égard, on notera que les tensions de référence VR1 et VR2 peuvent converger, pour un signal alternatif de grandeur décroissante, d'un échelon, par cycle mais qu'elles peuvent s'accroître, pour un signal alternatif de grandeur croissante, de plusieurs échelons par cycle.

Pour assurer que le circuit s'ajuste au signal présent et empêcher la production du signal de sortie 51 rectangulaire, tel que le signal de sortie représenté sur la figure 14, avant qu'un réglage correct n'ait été obtenu, par exemple lors de la mise en marche, un circuit logique de restauration à la mise sous tension « POR » met les compteurs 1 et 2 dans un état prédéterminé au moment de la mise sous tension. Le circuit utilisé à cette fin est le circuit logique POR 55 représenté sur la figure 8 qui a pour but d'assurer que les tensions de référence VR1 et VR2 s'ajustent pour envelopper respectivement la crête 49a et le creux 49b du signal 48. On doit noter que si les valeurs initiales des tensions de référence VR1 et VR2 étaient choisies telles que la tension du niveau de seuil de détection VTH ne se trouve pas à l'intérieur des limites de crête à crête du signal, l'appareil ne pourrait pas produire de signal de sortie ni ajuster les deux valeurs de référence.

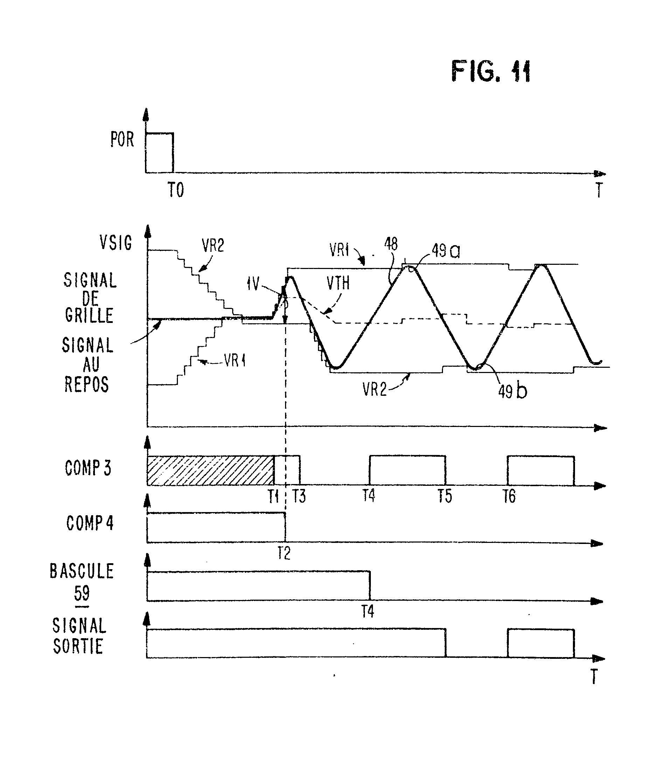

On se référera maintenant aux figures 10 et 11, la figure 10 représentant le circuit logique POR 55 tandis que la figure 11 est un diagramme des temps des signaux facilitant l'explication du fonctionnement du circuit logique POR 55 en combinaison avec les autres circuits du canal représenté sur la figure 8. Comme il est bien connu, lorsqu'un appareil électronique est mis sous tension, les circuits logiques de l'appareil doivent être initialisés (c'est-à-dire placés dans un état logique déterminé) avant que l'appareil ne soit prêt à fonctionner. Habituellement, on utilise un signal d'initialisation appelé signal de restauration à la mise sous tension, ou signal POR. Par conséquent, si l'on suppose que l'appareil vient juste d'être mis sous tension, le signal de restauration à la mise sous tension POR est à un haut niveau, comme représenté sur le diagramme des temps de la figure 11. Comme représenté sur la figure 10, le circuit logique POR 55 reçoit un signal d'entrée provenant du comparateur COMP3 (cf. figure 8) ainsi que les tensions de référence VR1 et VR2. Le signal de sortie du comparateur COMP3 est appliqué à une première porte OU 56 et le signal de sortie inversé du comparateur COMP3 est appliqué à une seconde porte OU 57, l'inversion du signal étant produite par un inverseur 58. Les signaux de tension de référence VR1 et VR2 sont appliqués à un quatrième comparateur COMP4 dont la sortie est raccordée à l'entrée de retard D d'une bascule 59 du type à retard. Le signal de la sortie Q, piloté par les impulsions d'horloge appliquées à l'entrée d'horloge CLK de la bascule 59, est appliqué à la seconde entrée de la porte OU 56 et à la seconde entrée de la porte OU 57. Ainsi, lorsque le signal de restauration à la mise sous tension POR est à un haut niveau, le signal de sortie de la bascule 59 est pré-réglé à un haut niveau, ce qui porte le signal de sortie rectangulaire à un haut niveau par l'intermédiaire de la porte OU 56. L'état du comparateur 3 est inconnu (ce qui correspond à la région hachurée du signal correspondant sur la figure 11) au cours de cette période. Jusqu'au temps T1. Au cours de la période pendant laquelle le signal POR est à un haut niveau, c'est-à-dire jusqu'au temps T0, période au cours de laquelle la machine est initialisée, la tension de référence VR1 est mise à sa valeur minimale tandis que la tension de référence VR2 est mise à sa valeur maximale (la tension de référence VR1 est inférieure à la valeur de crête minimale du signal et la tension de référence VR2 est supérieure à la valeur de creux maximale du signal, comme représenté sur le diagramme des temps). Le signal de sortie du comparateur COMP4 est à un haut niveau et est appliqué à l'entrée D de la bascule 59 au cours de la restauration à la mise sous tension. Lorsque le signal POR retombe à 0, au temps T0, les signaux de sortie des deux comparateurs COMP1 et COMP2 sont à un haut niveau, de sorte que le compteur 1 incrémente la tension de référence VR1 et le compteur 2 décrémente la tension de référence VR2, comme représenté sur le diagramme des temps. La tension de référence VR1 est incrémentée jusqu'à ce qu'elle soit supérieure à la valeur du signal, c'est-à-dire jusqu'à ce qu'elle soit tout juste plus grande que la valeur du signal au niveau de repos, comme indiqué sur le diagramme des temps (ce signal de repos est produit parce que le chariot ne se déplace pas par rapport à la grille à ce moment). Lorsque la tension de référence VR1 a été incrémentée de telle sorte qu'elle est plus grande que la valeur du signal, le signal de sortie du comparateur COMP1 retombe à un bas niveau. De la même manière, la tension de référence VR2 est décrémentée jusqu'à ce qu'elle devienne inférieure à la valeur du signal et, à ce moment, le signal de sortie du comparateur COMP2 tombe à un bas niveau.

Supposons qu'au temps T1 un déplacement relatif se produise entre le chariot 11 et la grille et que le signal varie tout d'abord dans le sens positif. La tension de référence VR1 suit la croissance du signal par échelons successifs ; au temps T2, la tension de référence VR1 est supérieure d'une tension prédéterminée, dans l'exemple réalisé : un volt, à la tension de référence VR2, ce qui provoque la retombée au niveau bas du signal de sortie du comparateur COMP4. Lorsque le signal franchit la tension du niveau de seuil de détection VTH, au temps T3, le signal de sortie du comparateur COMP3 tombe à un bas niveau et la tension de référence VR2 suit alors le signal à pente négative, par échelons successifs, comme représenté, enveloppant le creux du signal. Au temps T4, le signal de sortie du comparateur COMP3, passe d'un bas niveau à un haut niveau, du fait que le signal 48, avec une pente positive, franchit la tension du niveau de seuil de détection VTH. Ce signal est appliqué à l'entrée d'horloge CLK de la bascule 59. Étant donné que le signal appliqué à l'entrée D de la bascule 59 (signal de sortie du comparateur COMP4) est à un bas niveau au moment du front avant de cette impulsion d'horloge, le signal de la sortie Q de la bascule 59 retombe à 0 à ce moment.

Lorsque ce signal de sortie est à un bas niveau, le signal de sortie rectangulaire suit le signal de sortie du comparateur COMP3. En outre, la décrémentation du compteur 1 et l'incrémentation du compteur 2 peuvent maintenant être effectuées sous la commande des signaux de sortie des portes OU 56 et 57. Le signal de sortie rectangulaire effectue ainsi sa première transition de haut niveau à bas niveau au temps T5 tandis que le compteur 2 effectue sa première incrémentation au temps T5 et que le compteur 1 effectue sa première décrémentation au temps T6. Par conséquent, après le temps T4, on est assuré que les tensions de référence ont enveloppé le signal et qu'un fonctionnement correct est assuré à partir de ce point.

Le signal émanant des détecteurs D1 et D2 n'est, en réalité, pas aussi net qu'il serait désirable pour assurer un fonctionnement correct du circuit de la figure 8 lorsque le nombre de lignes au centimètre de la grille devient élevé. Par exemple, le signal de sortie du détecteur et les signaux qui sont appliqués aux comparateurs COMP1, COMP2 et COMP3 peuvent contenir de multiples configurations parasites, du type bruit, superposées à la forme d'onde du signal. Ce bruit pourrait nuire au processus de comptage, au travers des comparateurs COMP1 et COMP2, par les compteurs 1 et 2 ; les convertisseurs numérique/analogique D/A1 et D/A2 produiraient alors de nombreux échelons au lieu des seuls échelons successifs nécessaires pour suivre le signal 48. Par conséquent, on peut utiliser un circuit de désensibilisation automatique entre les comparateurs COMP1 et COMP2 et leur compteur respectif pour empêcher des comptages excessifs des compteurs. Le circuit utilisé à cette fin, représenté sur la figure 12, masque les signaux parasites, ou rebondissements, pendant une période de temps spécifiée après la mise en opération initiale du comparateur. Par exemple, et comme représenté sur la figure 12 et la figure 13 le circuit peut comporter une horloge, cette horloge produisant un signal de sortie qui est un multiple du signal de grille appliqué à l'appareil. Dans le mode de réalisation représenté, une bascule bistable L1 est enclenchée lorsque le signal de sortie du comparateur COMP1 et le signal d'horloge HL, appliqués à une porte ET INVERSE 60 sont tous deux à un haut niveau (le signal de sortie de cette porte est alors à un bas niveau et, par conséquent, appliqué à la borne S, enclenche, ou met à l'état 1, la bascule L1). Comme représenté, un compteur de temps, ou minuteur 70, est chargé par l'intermédiaire d'une porte OU 71 en même temps que la bascule L1 est enclenchée. Une bascule L2 est alors enclenchée, lorsque le signal de sortie de la bascule L1 et le signal d'horloge inversé HL appliqués à une porte ET INVERSE 61 sont simultanément à un haut niveau. Le signal de sortie de la bascule L1 et le signal de sortie de la bascule L2 inversé par un inverseur 62 sont appliqués au circuit ET inverse 66 pour appliquer un signal d'incrémentation au compteur 1. Comme représenté, les bascules L1 et L2 sont restaurées lorsque le signal de la sortie QD du minuteur 70 appliqué à la borne R de la bascule L1 retombe à 0. En effet, la bascule L1 revient à son état 0 ; un signal de sortie passe à un niveau bas et restaure la bascule L2. Le processus se répète dès que le signal de sortie du comparateur COMP1 passe à ce haut niveau après expiration de la période de temps de n impulsions d'horloge. Quand le signal de sortie du comparateur est resté à un haut niveau après expiration de la période de temps (ou est valablement passé à un haut niveau avant expiration de cette période de temps), une impulsion est engendrée toutes les n impulsions d'horloge. Dans ce mode de réalisation, le compteur de temps 70 est préchargé à un compte déterminé, par exemple 15, et est décrémenté jusqu'à 7 (compte pour lequel n = 8), moment auquel le signal de la sortie QD du minuteur 70 tombe à 0 remettant à 0 les bascules L1 et L2.

Le circuit de désensibilisation automatique fonctionne de la même manière. Le signal de sortie du comparateur COMP2 est appliqué par la porte ET INVERSE 63 à une bascule bistable L3 en même temps que le signal d'horloge HL ; la bascule L3 enclenchée provoque le chargement du minuteur 70 par l'intermédiaire du circuit OU 71. Une bascule bistable L4 est enclenchée lorsque le signal de sortie de la bascule L3 est appliqué en même temps que le signal d'horloge HL à la porte ET INVERSE 64 raccordée à l'entrée S de la bascule L4. Le signal de la sortie Q de la bascule L3 et le signal inversé de la sortie Q de la bascule L4 (inversé par l'inverseur 67) sont appliqués à une porte ET INVERSE 68 qui produit une impulsion de décrémentation du compteur 2. Les bascules L3 et L4 sont restaurées par le signal de la sortie QD du minuteur 70 de la même manière que les bascules L1 et L2.

La figure 13 représente un diagramme des temps caractéristique : les signaux de sortie des bascules L1 et L3 sont identiques et les signaux de sortie des bascules L2 et L4 le sont également. Aux fins de l'illustration, le compteur a été préréglé (sortie QD) à un compte de 15 pour permettre une transition à un compte de 7 (n = 8).

Ainsi, le circuit de détection de la présente invention fournit à la fois un signal d'indication de position et un signal d'indication du sens de déplacement de l'ensemble mobile, même lorsqu'il reçoit un signal qui varie en fréquence et en amplitude et en présence d'un courant continu de fuite. Ce résultat est obtenu en comparant une tension, calculée, du seuil de détection au signal d'entrée pour engendrer un signal prédéterminé, dans l'exemple représenté : un signal rectangulaire, dont la fréquence est une fonction de la fréquence du signal d'entrée.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Circuit de détection, destiné à engendrer un signal de sortie, dont la fréquence est fonction de celle du signal d'entrée et dont l'amplitude est insensible aux variations d'amplitude dudit signal d'entrée, comprenant :

— des premiers moyens (COMP1, COMPT1, D/A1) pour engendrer une première tension de référence (VR1), destinés à suivre les maxima d'amplitude (49a) du signal d'entrée (48),

— des seconds moyens (COMP2, COMPT2, D/A2) pour engendrer une seconde tension de référence (VR2), destinés à suivre les minima d'amplitude (49b) du signal d'entrée (48),

— des moyens (R1, R2) pour déterminer à partir des première et seconde tensions de référence (VR1, VR2), une tension de seuil de détection (VTH) qui varie en fonction de ces tensions de référence, et

— des moyens de comparaison entre la tension de seuil de détection et le signal d'entrée comprenant un circuit comparateur (COMP3) à deux bornes d'entrée, dont la première reçoit le signal d'entrée (48) et dont la seconde reçoit la tension de seuil de détection (VTH), caractérisé en ce que :

— les premier et second moyens comprennent des premier et deuxième comparateurs (COMP1, COMP2) qui permettent les comparaisons respectives des première et seconde tensions de référence (VR1, VR2) avec le signal d'entrée (48), et des premier et second compteurs (COMPT1, COMPT2), l'entrée d'incrémentation du premier compteur étant reliée à la sortie du premier comparateur et l'entrée de décrémentation du second compteur étant reliée à la sortie du deuxième comparateur, et en ce que des circuits logiques (55) reliés à la borne de sortie du circuit comparateur (COMP3) sont connectés d'une part à la borne de décrémentation (DEC) du premier compteur (COMPT1) afin de le décrémenter lorsque l'amplitude croissante du signal d'entrée (48) coïncide avec la tension de seuil de détection (VTH), le signal de sortie du circuit de détection étant constitué par le signal de décrémentation appliqué à la borne de décrémentation (DEC) du premier compteur (COMPT1), et d'autre part à la borne d'incrémentation (INC) du second compteur (COMPT2) afin de l'incrémenter lorsque l'amplitude décroissante du signal d'entrée coïncide avec cette tension de seuil de détection, la sortie du premier et celle du second compteur délivrant respectivement les premières et la seconde tensions de référence enveloppant l'amplitude crête-à-crête du signal d'entrée au cours d'un cycle complet de celui-ci.

2. Circuit de détermination de la phase relative de deux signaux électriques de même fréquence instantanée faisant application du circuit de détection défini à la revendication 1, caractérisé en ce qu'il comprend :

— un premier canal (A) formé par le circuit de détection selon la revendication 1 et recevant le premier signal,

— un second canal (B) formé par le circuit de détection selon la revendication 1 et recevant le second signal, et

— des circuits électriques (53, 54) recevant les signaux de sortie du premier et du second canal, qui indiquent dans leur signal de sortie la relation de phase entre ces signaux de sortie des premier et second canaux.

3. Appareil de détection de position et du sens du mouvement relatif de deux pièces l'une par rapport à l'autre, faisant application du circuit de détermination de la phase défini à la revendication 2, caractérisé en ce qu'il comprend :

— une grille (31) formée d'un premier et d'un second ensembles (32 et 33) de lignes opaques (32-1, 33-1) et de lignes transparentes (32-2, 33-2) à la lumière, inscrites sur du matériau transparent, le premier ensemble étant juxtaposé au second ensemble de telle sorte que le premier ensemble de lignes soit décalé par rapport au second ensemble de lignes selon le sens du déplacement relatif, et

— un ensemble source lumineuse-détecteur de lumière (35) consistant en deux sources lumineuses (S1, S2) et deux détecteurs de lumière (D1, D2), chaque source lumineuse étant associée à un seul détecteur de lumière pour former une paire de dispositifs de génération et de détection de lumière, chacune des deux paires étant placée d'un même côté de la grille, en ce que,

— un des deux dispositifs de la première paire est aligné avec le premier ensemble de lignes (32) tandis que le second dispositif de cette première paire est aligné avec le second ensemble de lignes (33) ; en ce que,

— les deux dispositifs de la seconde paire sont alignés avec seulement un des ensembles de lignes (33) de la grille ; en ce que

— l'axe de révolution (47) d'une surface réfléchissante (45, 46), placée de l'autre côté de la grille par rapport à l'ensemble source lumineuse-détecteur de lumière (35), passe par le point milieu de chaque segment déterminé par la source lumineuse et par le détecteur de lumière appartenant à une même paire de dispositifs ; en ce que,

— le mouvement relatif entre la grille (31) et l'ensemble source lumineuse-détecteur de lumière (35) est détecté du fait du déplacement de l'image des lignes opaques et des lignes transparentes de la grille devant les deux détecteurs, qui délivrent chacun un signal de sortie dont la différence de phase relative varie en fonction du mouvement relatif ; en ce qu'il comprend encore

— un circuit de détermination selon la revendication 2, permettant de détecter la phase relative d'un premier signal électrique issu du premier détecteur de lumière (D1) et d'un second signal électrique issu du second détecteur de lumière (D2), et de générer un signal de sortie représentatif de ces variations de phase.

## Claims

1. A detection circuit for generating an output signal whose frequency is a function of that of the input signal and whose amplitude is not subject to the amplitude variations of said input signal, comprising :

— first means (COMP1, COMPT1, D/A1) for generating a first reference voltage (VR1) to follow the maximum amplitude values (49a) of the input signal (48),

— second means (COMP2, COMPT2, D/A2) for generating a second reference voltage (VR2) to follow the minimum amplitude values (49b) of the input signal (48),

— means (R1, R2) for determining from the first and second reference voltages (VR1, VR2) a detection threshold voltage (VTH) varying as a function of these reference voltages, and

— comparison means between the detection threshold voltage and the input signal comprising a comparator circuit (COMP3) with two input terminals, the first one receiving the input signal (48) and the second one receiving the detection threshold voltage (VTH), characterized in that :

— the first and second means comprise first and second comparators (COMP1, COMP2) for comparing respectively the first and second reference voltages (VR1, VR2) with the input signal (48), and first and second counters (COMPT1, COMPT2), the increment input of the first counter being connected to the output of the first comparator and the decrement input of the second counter being connected to the output of the second comparator, and in that :

— logic circuits (55) connected to the output terminal of the comparator circuit (COMP3) are connected, on the one hand, to the decrement terminal (DEC) of the first counter (COMPT1) for decrementing it when the increasing amplitude of the input signal (48) matches the detection threshold voltage (VTH), the output signal of the detection circuit consisting of the decrement signal applied to the decrement terminal (DEC) of the first counter (COMPT1), and on the other hand to the increment terminal (INC) of the second counter (COMPT2) for incrementing it when the decreasing amplitude of the input signal matches this detection threshold voltage, the output of the first and second counters supplying respectively the first and second reference voltages covering the peak-to-peak amplitude of the input signal during a complete cycle thereof.

2. A circuit for determining the relative phase of two electrical signals with the same instantaneous frequency, embodying the detection circuit defined in claim 1, characterized in that it comprises :

— a first channel (A) formed by the detection circuit according to claim 1 and receiving the first signal,

— a second channel (B) formed by the detection circuit according to claim 1 and receiving the second signal, and

— electrical circuits (53, 54) receiving the output signals of the first and second channels and indicating in their output signal the phase relation between said output signals of the first and second channels.

3. A detection device for detecting the position and the direction of the relative movement of two parts with respect to each other, embodying the phase determination circuit defined in claim 2, characterized in that it comprises :

— a grating (31) formed by first and second sets (32 and 33) of opaque lines (32-1, 33-1) and transparent lines (32-2, 33-2) recorded on a transparent media, the first and second sets of lines being positioned side by side in such a way that the first set of lines is offset with respect to the second set of lines depending on the direction of the relative displacement, and

— a light source/light detector assembly (35) consisting of two light sources (S1, S2) and two light detectors (D1, D2), each light source being associated with only one light detector to form a pair of devices for light generation and detection, each of the two pairs being placed at the same side of the grating ; in that

— one of the two devices of the first pair is lined up with the first set of lines (32) whereas the second device of said first pair is lined up with the second set of lines (33) ; in that

— the two devices of the second pair are lined up with only one of the sets of lines (33) ; in that

— the rotation axis (47) of a reflecting surface (45, 46) positioned at the other side of the grating with respect to the light source/light detector assembly (35) goes through the center point of each segment determined by the light source and by the light detector belonging to the same pair of devices ; in that

— the relative movement between the grating (31) and the light source/light detector assembly (35) is detected as a result of the displacement of the image of opaque and transparent lines of the grating past the two detectors each of which delivering an output signal whose relative phase difference varies as a function of the relative movement ; and in that it further includes :

— a circuit according to claim 2 for detecting the relative phase of a first electrical signal generated by the first light detector (D1) and a second electrical signal generated by the second light detector (D2) and for generating an output signal indicating these phase variations.

## Ansprüche

1. Erkennungsschaltung zum Erzeugen eines Ausgangssignals, dessen Frequenz eine Funktion des Eingangssignals, und dessen Amplitude unempfindlich gegen Amplitudenvariationen dieses Eingangssignals ist, die einschliesst :

— erste Mittel (COMP1, COMPT1, D/A1) zum Erzeugen einer ersten Referenzspannung (VR1) zum Verfolgen der maximalen Amplitudenwerte (49a) des Eingangssignals (48),

— zweite Mittel (COMP2, COMPT2, A/D2) zum Erzeugen einer zweiten Referenzspannung (VR2) zum Verfolgen der minimalen Amplitudenwerte (49b) des Eingangssignals (48),

— Mittel (R1, R2) zum Erhalten aus der ersten und zweiten Referenzspannung (VR1, VR2) einer Erkennungsschwellen-Spannung (VHT), die von diesen Referenzspannungen abhaengt, und

— Vergleichsmittel zwischen der Erkennungsschwellen-Spannung und dem Eingangssignal, mit einer Vergleicherschaltung (COMP3) mit zwei Eingangsklemmen, wobei die erste das Eingangssignal (48) und die zweite die Erkennungsschwellen-Spannung (VTH) erhaelt, dadurch gekennzeichnet dass :

— die ersten und zweiten Mittel erste und zweite Vergleicherschaltungen (COMP1, COMP2) zum Vergleichen der ersten bzw. zweiten Referenzspannung (VR1, VR2) mit dem Eingangssignal (48), sowie erste und zweite Zaehler (COMPT1, COMPT2) einschliessen, wobei der Inkrementiereingang des ersten Zaehlers an den Ausgang der zweiten Vergleicherschaltung und der Dekrementiereingang des zweiten Zaehlers an den Ausgang der zweiten Vergleicherschaltung angeschlossen ist, und dass

— logische, mit der Ausgangsklemme der Vergleicherschaltung (COMP3) verbundene Schaltkreise (55), die einerseits an die Dekrementierklemme (DEC) des ersten Zaehlers (COMPT1) angeschlossen sind, um diesen zu dekrementieren, wenn die wachsende Amplitude des Eingangssignals (48) mit der Erkennungsschwellen-Spannung (VTH) uebereinstimmt, wobei das Ausgangssignal der Erkennungsschaltung von dem an die Dekrementierklemme (DEC) des ersten Zaehlers (COMPT1) angelegten Dekrementiersignal gebildet wird, und andererseits an die Inkrementierklemme (INC) des zweiten Zaehlers (COMPT2), um diesen zu inkrementieren, wenn die fallende Amplitude des Eingangssignals mit dieser Erkennungsschwellen-Spannung uebereinstimmt, wobei der Ausgang des ersten und der des zweiten Zaehlers die erste bzw. zweite Referenzspannung liefert, die die Spitze-zu-Spitze-Amplitude des Eingangssignals waehrend seines vollen Zyklus einschliesst.

2. Schaltung zum Feststellen der relativen Phase von zwei elektrischen Signalen der gleichen Augenblicksfrequenz, die die im Anspruch 1 definierte Erkennungsschaltung benutzt, dadurch gekennzeichnet, dass sie einschliesst :

— einen ersten Kanal (A), der von der Erkennungsschaltung nach Anspruch 1 gebildet wird und das erste Signal erhaelt,

— einen zweiten Kanal (B), der von der Erkennungsschaltung nach Anspruch 1 gebildet wird und das zweite Signal erhaelt, und

— elektrische Schaltkreise (53, 54), die die Ausgangssignale des ersten und zweiten Kanals erhalten und deren Ausgangssignal die Phasenbeziehung zwischen diesen Ausgangssignalen des ersten und zweiten Kanals angibt.

3. Erkennungsvorrichtung zum Erkennen der Position und der Richtung der relativen Bewegung von zwei Teilen zueinander, die die Schaltung zur Phasenbestimmung nach Anspruch 2 benutzt, dadurch gekennzeichnet, dass sie einschliesst :

— einen Raster (31), der aus einer ersten und zweiten Anordnung (32 und 33) undurchsichtiger Linien (32-1, 33-1) und durchsichtiger Linien (32-2, 33-2) besteht und auf einem durchsichtigen Material aufgezeichnet ist, wobei die erste Anordnung neben der zweiten Anordnung in der Weise steht, dass die erste Anordnung von Linien gegen die zweite Anordnung von Linien je nach der Richtung der relativen Bewegung verschoben wird, und

— eine Anordnung aus Lichtquelle und Licherkennungsvorrichtung (35) bestehend aus zwei Lichtquellen (S1, S2) und zwei Lichterkennungsvorrichtungen (D1, D2), wobei jede Lichtquelle einer einzigen Lichterkennungsvorrichtung zugeordnet ist, um eine Paar Lichterzeugungs- und Erkennungsvorrichtungen zu bilden, und wobei ein jedes der beiden Paare auf derselben Rasterseite steht ; dass

— die beiden Vorrichtungen des zweiten Paares mit nur einer der Anordnungen von Linien (33) des Rasters ausgerichtet sind ; dass

— die Rotationsachse (47) einer reflektierenden Oberflaeche (45, 46), die im Bezug auf die Anordnung aus Lichtquelle und Lichterkennungsvorrichtung (35) auf der anderen Seite des Raster angeordnet ist, durch den Mittelpunkt eines jeden Segments geht, das von der demselben Paar Vorrichtungen angehoerigen Lichtquelle und der Lichterkennungsvorrichtung bestimmt wird ; dass

— die Relativbewegung zwischen dem Raster (31) und der Anordnung aus Lichtquelle und Lichterkennungsvorrichtung (35) durch das Verschieben des Bildes aus undurchsichtigen Linien und durchsichtigen Linien des Rasters vor den beiden Erkennungsvorrichtungen bestimmt wird, von denen jede ein Ausgangssignal liefert, dessen relative Phasendifferenz in Abhaengigkeit der Relativbewegung variiert ; und dass sie ferner einschliesst

— eine Schaltung nach Anspruch 2 zum Erkennen der relativen Phase eines ersten, von der ersten Lichterkennungsvorrichtung (D1) ausgesandten elektrischen Signals und eines zweiten, von der zweiten Lichterkennungsvorrichtung (D2) ausgesandten elektrischen Signals, und zum Erzeugen eines diese Phasenvariationen darstellenden Ausgangssignals.

**FIG. 1**

**FIG. 2**

FIG. 3

FIG. 15

FIG. 4

FIG. 5

FIG. 16

# FIG. 6

# FIG. 7

# FIG. 8

# FIG. 9

# FIG. 10

# FIG. 11

FIG. 12

FIG. 13

FIG. 14